Europäisches Patentamt

European Patent Office

Office européen des brevets

(11) Veröffentlichungsnummer: **0 010 226**
**B1**

## (12) EUROPÄISCHE PATENTSCHRIFT

(45) Veröffentlichungstag der Patentschrift:
**04.05.83**

(21) Anmeldenummer: **79103781.5**

(22) Anmeldetag: **03.10.79**

(51) Int. Cl.³: **H 05 K  13/02,** H 05 K  13/00,
B 65 G  1/12

(54) **Bestückungstisch für Leiterplatten.**

(30) Priorität: **24.10.78  DE 2846262**

(43) Veröffentlichungstag der Anmeldung:
**30.04.80 Patentblatt 80/9**

(45) Bekanntmachung des Hinweises auf die Patenterteilung:
**04.05.83 Patentblatt 83/18**

(84) Benannte Vertragsstaaten:
**AT BE CH DE FR GB IT NL SE**

(56) Entgegenhaltungen:
**DE-A-2 625 738**
**DE-A-2 744 235**
**DE-A-2 751 856**

(73) Patentinhaber: **Lemmer, Alfred, Machtlfingerstrasse 24,
D-8000 München 70 (DE)**

(72) Erfinder: **Lemmer, Alfred, Machtlfingerstrasse 24,
D-8000 München 70 (DE)**

(74) Vertreter: **Schmidt-Evers, Jürgen, Patentanwälte
Dipl.-Ing. H. Mitscherlich Dipl.-Ing. K. Gunschmann
Dr.rer.nat. W. Körber Dipl.-Ing. J. Schmidt-Evers
Steindorfstrasse 10, D-8000 München 22 (DE)**

Bestückungstisch für Leiterplatten

Die Erfindung betrifft einen Bestückungstisch für Leiterplatten mit einem Bestückungsplatz, an dem die Bauelemente von Hand aus mittels einer umlaufenden Fördereinrichtung transportierten Griffschalen entnommen und in eine dort gehalterte, zu bestückende Leiterplatte eingesetzt werden, sowie mit einem auf dem Bestückungstisch angeordneten Magazin, in welchem ICs angeordnet enthalten sind.

Ein derartiger Bestückungstisch ist bekannt. Bei diesem bekannten Bestückungstisch werden Bauelemente, die keine ICs sind, z. B. Widerstände, Kondensatoren od. dgl. in den Griffschalen antransportiert, von den die Bestückung vornehmenden Personen aus den Griffschalen entnommen und dann in die Leiterplatte eingesetzt. ICs muß die die Bestückung vornehmende Person aus dem auf dem Bestückungstisch angeordneten Magazin mit einer Bestückungszange entnehmen. Dazu muß jedoch die die Bestückung vornehmende Person eine von den üblichen Bewegungen abweichende Bewegung mit langem Zugriffsweg machen. Die übliche Bewegung erfolgt nur zwischen der am Bestückungsplatz befindlichen Griffschale und der unmittelbar daneben angeordneten Leiterplatte.

Das Anliefern von ICs in Griffschalen ist nicht ohne weiteres möglich, weil die ICs wegen der Vielzahl ihrer Anschlüsse mit der Hand voneinander getrennt werden müssen und weil dabei die Gefahr der Berührung der Anschlüsse und damit einer Zerstörung der ICs durch elektrostatische Aufladung der die Bestückung vornehmenden Person verbunden ist.

Der Erfindung liegt daher die Aufgabe zugrunde, einen Bestückungstisch der eingangs beschriebenen Art so auszubilden, daß unter Beibehaltung der Möglichkeit einer Aufnahme der ICs mit einer Bestückungszange ein kurzer Griffweg gewährleistet ist, der nicht von dem für andere Bauelemente abweicht.

Die Aufgabe ist erfindungsgemäß dadurch gelöst, daß in die für die ICs bestimmten Griffschalen auswechselbare Einsätze eingesetzt sind, die an die Form der ICs angepaßte Aufnahmeöffnungen aufweisen, und daß an einem vom Bestückungsplatz entfernten Ladeplatz eine automatisch arbeitende Übertragungsvorrichtung vorgesehen ist, die dem Magazin jeweils einen IC entnimmt und die in die Aufnahmeöffnung des jeweiligen Griffschaleneinsatzes in vorgegebener Lage einsetzt.

Es ist zwar eine automatisch arbeitende Bestückungsmaschine (DE-A1-2 744 235 bekannt, bei der auf dem Bestückungstisch ein Magazin angeordnet ist, in welchem die ICs geordnet lagern, sowie eine Übertragungsvorrichtung, die jeweils einen IC dem Magazin entnimmt, zum Bestückungsplatz transportiert und dort ausgerichtet einem Einsetzkopf abgibt, der die ICs in die Leiterplatte einsetzt; bei dieser Maschine ist jedoch weder eine Handbestükkung vorgesehen, noch werden Griffschalen verwendet. Somit tritt die oben geschilderte Problematik hier nicht auf.

Die erfindungsgemäße Lösung macht es möglich, daß auch für ICs die sonst für normale Bauelemente vorgesehenen Griffschalen verwendet werden können. Die auswechselbaren Einsätze sind entfernbar, so daß eine leichte Umrüstung jederzeit möglich ist. Die Aufnahmeöffnungen in den Einsätzen gewährleisten, daß die ICs an den Bestückungsplatz in einer bestimmten Ausrichtung transportiert werden, wodurch eine schnelle und problemlose Übertragung der ICs am Bestückungsplatz aus den Einsätzen von Hand in die Leiterplatte möglich ist.

Die Erfindung wird durch die Merkmale der Unteransprüche weitergebildet.

Durch die Erfindung ist es also möglich, daß selbst bei einer Vielzahl verschiedenartiger Bauelemente dem Bestückungsplatz die einzelnen Bauelemente, unter denen sich auch verschiedenartige ICs befinden können, in vorgegebener Folge und vorgegebener Lage zugeführt werden, wobei das Einsetzen der Bauelemente und insbesondere der sehr empfindlichen ICs mit sehr kurzem Griffweg möglich ist. Da die Aufnahmeöffnung in der Griffschale bzw. einem Einsatz für die Griffschale so ausgebildet sein kann, daß eine Zwangsführung für die IC-Bestückungszange erreicht wird, wird das Entnehmen des ICs aus der Griffschale wesentlich erleichtert und wird auch jede Zerstörung durch statische Aufladung vermieden. Dabei können die Übertragungsvorrichtung, das drehbare Magazin und die Griffschale jeweils so aufeinander abgestimmt und so gesteuert sein, daß sichergestellt wird, daß nur ganz bestimmte ICs dem drehbaren Magazin entnehmbar und dem Bestückungsblatt zuführbar sind. Eine solche Steuerung kann beispielsweise durch Synchronisation erfolgen oder auch durch eine Kodierung der jeweiligen Griffschalen und der den dort einzusetzenden ICs entsprechenden Sammelbereichen des vorzugsweise drehbaren Magazins. Dies ist insbesondere dann vorteilhaft, wenn verschiedene unterschiedliche ICs in die Leiterplatte eingesetzt werden sollen und wenn das Einsetzen von ICs und von anderen Bauelementen einander abwechseln. Dabei kann der Antrieb der einzelnen Bauteile der Übertragungsvorrichtung über Pneumatikzylinder erfolgen.

Gemäß einem bevorzugten Ausführungsbeispiel ist das drehbare Magazin karusselähnlich ausgebildet und weist seitlich mehrere vertikale Aufnahmeschienen für die ICs auf. Die Übertragungsvorrichtung ist gegenüber dem Karussel radial verschiebbar angeordnet und enthält ein vorzugsweise als Zange ausgebildetes Entnahmeglied. Diese Entnahmezange besitzt einen Öffnungsbereich, der zumindest so groß ist, daß er auch die breitest möglichen ICs erfassen kann. Die Entnahmezange entnimmt die ICs aus den Sammelschienen in radialer horizontaler Richtung und bewegt sich zunächst von dem Karussel weg. Dann kippt die Entnahmezange um eine Horizontalachse nach unten derart, daß das IC mit nach unten weisenden Anschlußstiften angeordnet ist. Dann wird die Entnahmezange mit dem IC abgesenkt, derart, daß der IC in die vorzugsweise den Anschlußstiften entsprechende Stecklöcher aufweisende Aufnahmeöffnung des Einsatzes der betreffenden Griffschale eingesetzt oder gesteckt wird. Dann wird die Entnahmezange wieder herausgehoben und in die Ausgangslage zurückgedreht, wobei dann ein neuer Übertragungsvorgang ausgelöst werden kann.

Die Erfindung wird anhand des in der Zeichnung dargestellten Ausführungsbeispiels näher erläutert. Es zeigt

Fig. 1 in Aufsicht schematisch einen erfindungsgemäß ausgebildeten Bestückungstisch,

Fig. 2 in Seitenansicht in Teilschnitt eine Übertragungsvorrichtung gemäß der Erfindung mit zugeordnetem Magazin und zugeordneter Griffschale,

Fig. 3 in Aufsicht die Anordnung gemäß Fig. 2,

Fig. 4 den Schnitt IV-IV in Fig. 2,

Fig. 5 die Übertragungsvorrichtung gemäß Fig. 2 nach Verschwenkung um die Horizontalachse,

Fig. 6 in Aufsicht die Übertragungsvorrichtung gemäß Fig. 5.

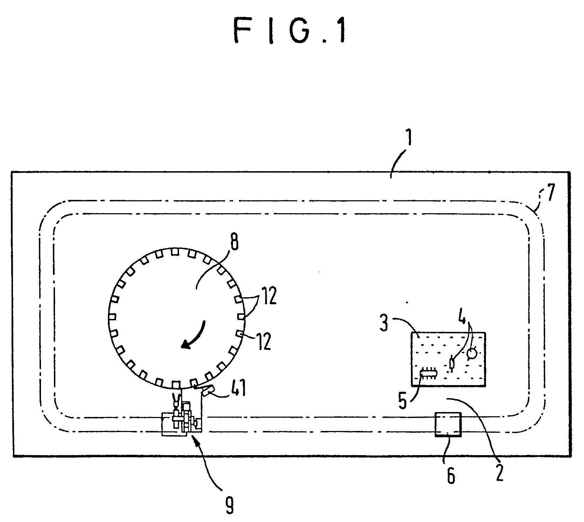

Fig. 1 zeigt in Aufsicht einen Bestückungstisch 1, der im rechten unteren Bereich (Fig. 1) einen Bestückungsplatz 2 besitzt. Am Bestückungsplatz 2 ist eine zu bestückende Leiterplatte 3 gehalten. In diese Leiterplatte 3 sind diskrete Bauelemente 4, wie Widerstände, Transistoren, Kondensatoren usw. einsetzbar, wobei auch ICs 5 eingesetzt werden müssen.

Zum Bestücken werden die Bauelemente 4, 5 aus einer dem Bestückungsplatz 2 zugeführten Griffschale 6 entnommen. Solche Griffschalen, die jeweils nur eine Art eines Bauelements 4, 5 aufnehmen, werden mit einer Fördereinrichtung 7 längs des Bestückungstisches 1 umlaufend gefördert. Das heißt, daß zumindest soviel Griffschalen 6 vorgesehen sein müssen, als unterschiedliche Bauelemente 4, 5 in die Leiterplatte 3 einzusetzen sind.

Für das Einsetzen von ICs 5 in die Leiterplatte 3 hat es sich als nachteilig erwiesen, wenn mehrere gleichartige ICs in der Griffschale enthalten sind, da sich deren Anschlußstifte und Anschlußfahnen ineinander verkrallen können, weshalb die Bedienperson den zu entnehmenden IC 5 von den übrigen ICs von Hand trennen mußte. Außerdem muß zum Einsetzen der ICs 5 in die Leiterplatte 3 eine spezielle Bestückungszange benutzt werden.

Da das Berühren der ICs mit der Hand zu einer Zerstörung des ICs aufgrund statischer Aufladung der Bedienperson führen kann, wurde schon versucht, dies dadurch zu umgehen, daß die ICs nicht einer Griffschale 6 entnommen werden, sondern einem vorzugsweise drehbaren Magazin 8 entnommen werden, in dem die jeweiligen ICs in vorgegebener Lage enthalten sind, wobei die Bedienperson mit der IC-Bestückungszange zum drehbaren Magazin 8 greift, dort den IC 5 ergreift und ihn dann in die Leiterplatte 3 einsetzt. Dies führt jedoch zu sehr langen Griffwegen, wodurch die Sicherheit der Entnahme des ICs 5 aus dem drehbaren Magazin 8 beeinträchtigt ist. Da außerdem die übrigen diskreten Bauelemente 4 weiterhin den zugeführten Griffschalen 6 entnommen werden, führt diese Vorgehensweise zu zwei vollständig verschiedenen Bestückungsvorgängen, wodurch es insbesondere bei Handbestückung zu Störungen aufgrund von Irrtümern kommen kann.

Es wird daher ein in die zu bestückende Leiterplatte 3 einzusetzender IC 5 nicht mehr direkt dem drehbaren Magazin entnommen, sondern wieder der Griffschale 6 entnommen, und zwar in vorgegebener Lage. Dazu ist am Bestückungstisch 1 eine Übertragungsvorrichtung 9 vorgesehen, die automatisch arbeitet und dem drehbaren Magazin 8 einen IC 5 entnimmt und diesen IC 5 in eine in der Griffschale 6 vorgesehene, an den jeweiligen IC angepaßte Aufnahmeöffnung einsetzt.

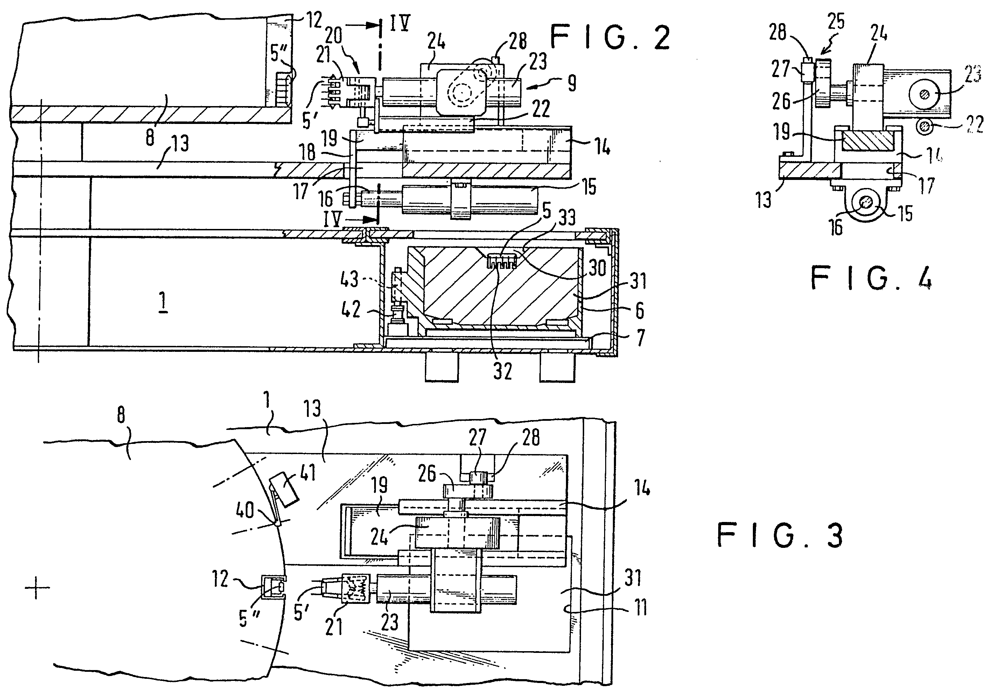

Die in Fig. 1 nur schematisch dargestellte Übertragungsvorrichtung 9 wird anhand des in den Fig. 2 bis 6 dargestellten Ausführungsbeispiels ausführlich erläutert.

Beim dargestellten Ausführungsbeispiel weist der Tisch 1 eine solche Fördereinrichtung 7 der Griffschale 6 auf, daß Zugriff zur Griffschale 6 nur durch eine Öffnung 11 in der Tischplatte des Tisches 1 erfolgen kann, wodurch ein Schutz erreicht wird. Über dem Tisch 1 ist das drehbare Magazin 8 angeordnet, wobei längs des Umfangs des Magazins vertikale Sammelschienen 12 vorgesehen sind, in denen jeweils ICs 5, 5', 5'' einer bestimmten Art und in bestimmter Ausrichtung gespeichert sind.

Parallel zum Tisch 1 ist beim Ausführungsbeispiel eine Konsole 13 vorgesehen, die eine Schlittenführung 14 oberhalb der Öffnung 11 des Tisches 1 und radial zum drehbaren Magazin 8 trägt. Unter der Konsole 13 ist ein pneumatischer Schiebezylinder 15 befestigt, dessen Kolbenstange 16 über eine durch einen Schlitz 17 der Konsole greifende Platte 18 mit einem Schlitten 19 verbunden ist, wobei der Schlitten 19 in der Schlittenführung 14 geführt ist und durch Betätigung des Verschiebezylinders 15 horizontal bewegbar ist. Zur Entnahme der ICs 5, 5', 5'' aus der Sammelschiene 12 und zu deren Einsetzen in die Griffschale 6 weist die Übertragungsvorrichtung eine Greifeinrichtung 20 auf, die mit dem Schlitten verbunden ist. Die Greifeinrichtung 20 enthält eine Entnahmezange 21, deren Zangenbacken zum Ergreifen eines ICs 5, 5', 5'' ausgebildet sind. Das Öffnen und Schließen der Entnahmezange 21 erfolgt mittels eines pneumatischen Stellzylinders 22, der an der Entnahmezange 21 befestigt ist, wobei dessen Kolbenstange auf die Zangenbacken der Entnahmezange 21 einwirkt. Die Entnahmezange 21 selbst ist an der Kolbenstange eines weiteren Verstellzylinders 23 befestigt. Am Schlitten 19 ist eine Drehhalterung 24 befestigt, in der bzw. an der die Greifeinrichtung 20 drehbar gelagert ist. Eine Verdrehung oder Verschwenkung der Greifeinrichtung 20 um eine horizontale zur Schlittenverschieberichtung senkrechte Richtung ist mittels einer Schwenkeinrichtung 25 erreichbar. Diese Schwenkeinrichtung 25 kann beispielsweise durch einen Drehantrieb, wie einen Motor oder dergleichen, erfolgen. Beim dargestellten Ausführungsbeispiel erreicht die Schwenkeinrichtung 25 eine Verschwenkung der Greifeinrichtung 20 aus der Horizontalstellung gegenüber dem drehbaren Magazin 8 um 90° in eine vertikale Stellung gegenüber der Griffschale 6. Die Schwenkeinrichtung 25 besteht beim dargestellten Ausführungsbeispiel aus einem Nockenhebel 26 mit einem Nocken 27, der gegen einen Anschlag 28 geführt wird, der mit der Konsole oder der Schlittenführung 14 einstückig ist, wobei durch das Führen des Nockens 27 gegen den Anschlag 28 die Verschwenkung ausgelöst wird. Selbstverständlich kann auch ein anderer Verschwenkwinkel durch geeignete Ausbildung des Nockenhebels 26 und des Anschlags 28 erreicht werden, falls dies zweckmäßig ist.

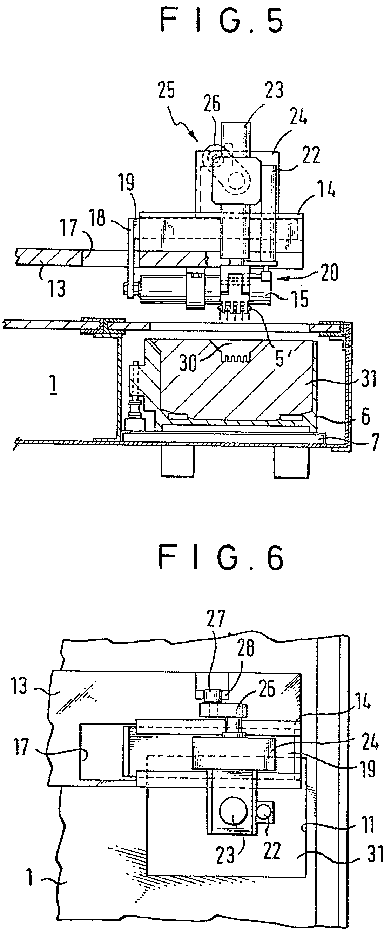

Die um 90° verschwenkte Stellung ist in Fig. 5 dargestellt. Bei dieser um 90° verschwenkten Stellung befindet sich die Greifeinrichtung 20 gegenüber einer Aufnahmeöffnung 30 der Griffschale 6, wobei die Aufnahmeöffnung 30 in einem in die Griffschale 6 eingesetzten Einsatz 31 ausgebildet ist. Dadurch können auf der Fördereinrichtung 7 befestigte Griffschalen 6 stets verbleiben und wird bei einer Änderung des einzusetzenden ICs lediglich der Einsatz 31 ausgetauscht, der dann eine dem jeweiligen IC zugeordnete Aufnahmeöffnung 30 besitzt. Die Aufnahmeöffnung 30 weist vorzugsweise entsprechende Stecklöcher 32 für die Anschlußstifte bzw. Anschlußfahnen des jeweils der Aufnahmeöffnung 30 zugeordneten ICs 5 auf. Auf diese Weise wird der IC 5 in einer stets reproduzierten Lage in die Aufnahmeöffnung 30 eingesetzt, wenn die den IC 5' halternde Entnahmezange 21 nach der Verschwenkung mittels des Stellzylinders 22 wieder so gelöst wird, daß der IC 5' nunmehr in die Aufnahmeöffnung 30 abgesetzt wird, wobei vorzugsweise mittels des Stellzylinders 23 die Greifeinrichtung 20 auf die Aufnahmeöffnung 30 zubewegbar ist.

Nach dem Absetzen des ICs 5' in die Aufnahmeöffnung 30 wird die Greifeinrichtung wieder in die horizontale Lage (Fig. 2) zurückverschwenkt und wird die Griffschale 6 mittels der Fördereinrichtung 7 gefördert.

Vorzugsweise weist die Aufnahmeöffnung 30 außerdem eine Zwangsführung auf, die im dargestellten Ausführungsbeispiel durch eine Schrägführung 33 gebildet ist. Dadurch wird einerseits erreicht, daß am Bestückungsplatz 2 die IC-Bestückungszange zwangsweise zum Eingriff mit dem IC 5 in der Aufnahmeöffnung 30 kommt und daß andererseits auch der IC 5, 5' von der Greifeinrichtung 20 richtig und zwangsweise eingesetzt wird.

Häufig müssen auch ICs unterschiedlicher Typen in die Leiterplatte 3 eingesetzt werden. Dazu weist das drehbare Magazin 8 die Sammelschienen 12 auf, wobei je nach Art des in die Griffschale 6 einzusetzenden ICs 5, 5', 5'' die entsprechende Sammelschiene 12 der Übertragungseinrichtung 9 gegenüberliegend angeordnet werden muß. Dies wird vorteilhaft mittels einer Positioniersteuerung erreicht. Diese kann beispielsweise durch einen Rastnocken 40 in vorgegebener Lage am drehbaren Magazin 8 und eine mit dem Rastnocken 40 zusammenwirkende Schalteinrichtung, wie beispielsweise einem Mikroschalter 41, an der Übertragungsvorrichtung 9 erreicht werden. Erst wenn mittels der Schalteinrichtung über den Eingriff in den Rastnocken 40 erfaßt ist, daß die jeweilige benötigte Sammelschiene 12 der Greifeinrichtung 20 gegenüberliegend angeordnet ist, wird der Betrieb der Übertragungseinrichtung 9 ausgelöst. Weiter ist vorzugsweise auch eine Auslöseeinrichtung vorgesehen, die mit der Griffschale 6 zusammenwirkt, wobei dies beispielsweise auch über eine Schalteinrichtung 42 erreicht wird, die mit der Griffschale 6 zusammenwirkt, beispielsweise über einen Nocken 43. Selbstverständlich können Positioniersteuerung 40, 41 und Auslöseeinrichtung 42, 43 zusammenwirken.

Vorzugsweise ist die Auslöseeinrichtung 42, 43 so ausgebildet, daß eine Kodierung erreichbar ist, um zu erfassen, ob die Aufnahmeöffnung 30 der Griffschale 60 dem aus der Sammelschiene 12 entnehmbaren IC 5'' zugeordnet ist. Eine derartige Kodierung kann dabei auf mechanischem Wege durch eine Mehrfachnockensteuerung oder auch auf elektronischem Wege erfolgen. Vorzugsweise wirkt insbesondere in diesem Fall auch die Positioniersteuerung 40, 41 in ähnlicher Weise mit der Auslöseeinrichtung 42, 43 zusammen. Auf diese kann vorteilhaft programmgesteuert dem Bestückungsplatz 2 stets der jeweils benötigte IC 5, 5', 5'' in richtiger Folge zugeführt werden.

Schließlich ist es auch möglich, die Greifeinrichtung 20 mit einer Dreheinrichtung zu versehen, die die Greifeinrichtung um einen bestimmten Winkel vor dem Einsetzen in die Aufnahmeöffnung 30 so in der Ebene des Tisches 1 verdreht, daß beim Einsetzen in die Leiterplatte 3 die IC-Bestückungszange nicht mehr gedreht werden muß. Vorzugsweise weist dabei die Greifeinrichtung 20 ein Erfassungsglied auf, das feststellt, wie der IC 5'' in der Sammelschiene 12 ausgerichtet ist. Dies kann beispielsweise dadurch erfolgen, daß die U-förmige Ausnehmung an einer Breitseite des ICs erfaßt wird. Abhängig davon, wo sich diese Ausnehmung befindet, kann dann eine Verdrehung um 180° erfolgen, wodurch es nicht mehr erforderlich ist, die ICs in die Sammelschiene in vorgegebener Ausrichtung einzuführen. Diese Weiterbildungen sind insbesondere dann zweckmäßig, wenn eine vollautomatische Bestückung der Leiterplatte durchgeführt werden soll.

Selbstverständlich kann die erfindungsgemäße Lehre auch für die Zufuhr diskreter Bauelemente in vorgegebener Lage zum Bestückungsplatz 2 verwendet werden, wobei dies vor allem dann zweckmäßig sein dürfte, wenn eine automatische Bestückung durchgeführt werden soll.

## Patentansprüche

1. Bestückungstisch für Leiterplatten mit einem Bestückungsplatz, an dem Bauelemente von Hand aus mittels einer umlaufenden Fördereinrichtung transportierten Griffschalen entnommen und in eine dort gehaltene, zu bestückende Leiterplatte eingesetzt werden, sowie mit einem auf dem Bestückungstisch angeordneten Magazin, in welchem ICs geordnet enthalten sind, dadurch gekennzeichnet, daß in die für die ICs bestimmten Griffschalen (6) auswechselbare Einsätze (31) eingesetzt sind, die an die Form der ICs angepaßte Aufnahmeöffnungen (30) aufweisen, und daß an einem vom Bestückungsplatz (2) entfernten Ladeplatz (11) eine automatisch arbeitende Übertragungsvorrichtung (9) vorgesehen ist, die dem Magazin (8) jeweils einen IC (5, 5', 5'') entnimmt und in die Aufnahmeöffnung (30) des jeweiligen Griffschaleneinsatzes (31) in vorgegebener Lage einsetzt.

2. Bestückungstisch nach Anspruch 1, dadurch gekennzeichnet, daß die Übertragungsvorrichtung (9) aufweist:
ein Entnahmeglied mit einer Greifeinrichtung (20) zum Erfassen eines ICs (5) im Magazin (8) und zum Lösen des Entnahmeglieds vom IC (5) bei dessen Einsetzen in die Aufnahmeöffnung (30),
eine Schwenkeinrichtung (24, 25) zum Verschwenken des Entnahmeglieds aus der Entnahmestellung (Fig. 2), in der ein IC (5) dem Magazin (8) entnehmbar ist, in eine Einsetzstellung (Fig. 5), in der der IC (5) in die Aufnahmeöffnung (30) einsetzbar ist und umgekehrt.

3. Bestückungstisch nach Anspruch 2, dadurch gekennzeichnet, daß das Entnahmeglied eine Entnahmezange (21) ist, deren Backen durch die Greifeinrichtung (20) zusammen- bzw. auseinanderführbar sind.

4. Bestückungstisch nach Anspruch 2 oder 3, gekennzeichnet durch eine Vorschubeinrichtung (23, 14-19), um einen ergriffenen IC (5') vor dem Verschwenken geradlinig aus einer Entnahmeöffnung des Magazins (8) herauszuführen.

5. Bestückungstisch nach einem der Ansprüche 2 bis 4, gekennzeichnet durch eine Nachschubeinrichtung (23), um einen ergriffenen IC (5') nach der Verschwenkung geradlinig in die Aufnahmeöffnung (30) einzuführen.

6. Bestückungstisch nach Anspruch 5, dadurch gekennzeichnet, daß eine einzige Hubeinrichtung (23) Vor- und Nachhub erreicht.

7. Bestückungstisch nach Anspruch 6, dadurch gekennzeichnet, daß Vorhub und Nachhub gleiche Hubhöhe besitzen.

8. Bestückungstisch nach einem der Ansprüche 2 bis 6, gekennzeichnet durch eine gerade Führung (14-18) zur Führung der Übertragungsvorrichtung (9) parallel zum Bestückungstisch (1) vor und/oder während der Verschwenkung.

9. Bestückungstisch nach Anspruch 8, dadurch gekennzeichnet, daß die gerade Führung (14-18) durch eine mit dem Bestückungstisch (1) einstückige Schlittenführung (14) und einen mit der Schwenkeinrichtung (25) verbundenen Schlitten (19) gebildet ist.

10. Bestückungstisch nach Anspruch 8 oder 9, gekennzeichnet durch einen Nockenhebel (26) mit einem Nocken (27), der bei der Geradeführung durch Führen gegen einen Anschlag (28) die Verschwenkung auslöst.

11. Bestückungstisch nach einem der Ansprüche 2 bis 10, gekennzeichnet durch Pneumatikzylinder (15, 16, 23) zur Steuerung der geradlinigen Bewegungen.

12. Bestückungstisch nach einem der Ansprüche 2 bis 11, gekennzeichnet durch einen Pneumatikzylinder (22) zur Steuerung der Greifeinrichtung (20).

13. Bestückungstisch nach einem der Ansprüche 1 bis 12, gekennzeichnet durch eine mit dem Bestückungstisch (1) einstückige, zu ihm parallele Konsole (13) in Verbindung mit dem Magazin (8), an der die Übertragungsvorrichtung (9), gegebenenfalls die Schlittenführung (14), angebracht ist.

14. Bestückungstisch nach einem der Ansprüche 1 bis 13, dadurch gekennzeichnet, daß die Aufnahmeöffnung (30) so im Einsatz (31) vorgesehen ist, daß die IC-Bestückungszange beim Herausführen eines eingesetzten ICs (5) zwangsgeführt ist.

15. Bestückungstisch nach Anspruch 14, dadurch gekennzeichnet, daß die Aufnahmeöffnung (30) Stecklöcher (32) für die Anschlußfahnen und/oder -stifte des jeweiligen ICs (5) aufweist.

16. Bestückungstisch nach einem der Ansprüche 1 bis 15, dadurch gekennzeichnet, daß das drehbare Magazin (8) mehrere vertikale Aufnahmeschienen (12) für je eine bestimmte IC-Art (5'') aufweist.

17. Bestückungstisch nach Anspruch 16, gekennzeichnet durch eine Drehsteuerung des drehbaren Magazins (8), die abhängig von der Art des in die jeweilige Aufnahmeöffnung (30) einzusetzenden ICs (5) die entsprechende Aufnahmeschiene (12) zur Entnahme mittels der Übertragungsvorrichtung (9) dieser gegenüber ausrichtet.

18. Bestückungstisch nach Anspruch 17, gekennzeichnet durch eine Positioniersteuerung (40, 41) zum Ausrichten der jeweiligen IC-Aufnahmeschiene (12) gegenüber der Übertragungsvorrichtung (9).

19. Bestückungstisch nach Anspruch 18, dadurch gekennzeichnet, daß die Positioniersteuerung Rastnocken (40) in vorgegebener Lage am Magazin (8) und eine mit einem Rastnocken (40) zusammenwirkende Schalteinrichtung, wie einen Mikroschalter (41), aufweist, um abhängig von einem Eingriff zwischen Rastnocken (40) und Schalteinrichtung die Übertragungsvorrichtung (9) auszulösen.

20. Bestückungstisch nach einem der Ansprüche 1 bis 19, gekennzeichnet durch eine Auslöseeinrichtung (42, 43) zum Auslösen der Übertragungsvorrichtung (9), wenn die Aufnahmeöffnung (30) in vorgegebener Lage gegenüber der Übertragungsvorrichtung (9) angeordnet ist.

21. Bestückungstisch nach Anspruch 20, dadurch gekennzeichnet, daß die Auslöseeinrichtung eine mit der Griffschale (6) gegebenenfalls dem Einsatz (31) oder der Aufnahmeöffnung (30) zusammenwirkende Schalteinrichtung (42) aufweist.

22. Bestückungstisch nach einem der Ansprüche 19 bis 21, dadurch gekennzeichnet, daß die Positioniersteuerung (40, 41) und die Auslöseeinrichtung (42, 43) zusammenwirken.

23. Bestückungstisch nach Anspruch 22, dadurch gekennzeichnet, daß die Auslöseeinrichtung (42, 43) kodierbar ist, um abhängig von der jeweiligen Kodierung eine vorgegebene Aufnahmeschiene (12) des Magazins (8) in bezug auf die Übertragungsvorrichtung (9) zu positionieren.

24. Bestückungstisch nach einem der Ansprüche 1 bis 23, dadurch gekennzeichnet, daß programmgesteuert nur bei Bedarf und in vorgegebener Folge ICs (5) vom Magazin (8) zum Bestückungsplatz (2) über die Übertragungsvorrichtung (9) die mit der Aufnahmeöffnung (30) versehene Griffschale (6) und einer Griffschalen-Fördereinrichtung (7) zuführbar sind.

25. Bestückungstisch nach einem der Ansprüche 2 bis 24, gekennzeichnet durch eine Dreheinrichtung zum Drehen des Entnahmegliedes nach Entnahme des ICs (5) aus dem Magazin (8) und vor dessen Einsetzen in die Aufnahmeöffnung (30), zu dessen Ausrichtung gegenüber der Aufnahmeöffnung (30).

26. Bestückungstisch nach Anspruch 25, gekennzeichnet durch ein Erfassungsglied zum Erfassen der Ausrichtung der Längsachse des ICs (5) im Magazin (8) und eine Drehsteuerung der Dreheinrichtung zu deren Auslösung um den IC (5), gegebenenfalls zusätzlich, um 180° um seine Längsachse zu drehen.

27. Bestückungstisch nach Anspruch 25 oder 26, dadurch gekennzeichnet, daß die Aufnahmeöffnung (30) in jeweils vorgegebener, der endgültigen Lage des ICs (5) in der Leiterplatte (3) zugeordneten Lage in der Griffschale (6) angeordnet ist.

**Claims**

1. Assembly table for printed boards having an assembly position at which a printed board to be assembled is supported and at which component parts are removed by hand from open containers, transported by means of a circulating conveying installation, and are inserted into the printed board, and also having a magazine which is arranged on the assembly table and in which integrated circuits are contained in an ordered manner, characterised
in that interchangeable inserts (31), which have receiving openings (30) adapted to the form of the integrated circuits, are inserted into the open containers (6) which are intended for the integrated circuits and
in that at a loading place (11) remove from the assembly position (2) there is provided an automatically operating transfer apparatus (9) which removes in each case one integrated circuit (5, 5', 5'') from the magazine (8) and inserts it into the receiving opening (30) of the respective insert of the open containers (31) in a given position.

2. Assembly table according to claim 1, characterised in that the transfer apparatus (9) has:
a removal member having a gripping device (20) for taking hold of an integrated circuit (5) in the magazine (8) and for releasing the removal member from the integrated circuit (5) when the latter is inserted into the receiving opening (30),
a swivelling device (24, 25) for swivelling the removal member out of the removal position (Fig. 2), in which an integrated circuit (5) can be removed from the magazine (8), into an insertion position (Fig. 5), in which the integrated circuit (5) can be inserted into the receiving opening (30) and vice versa.

3. Assembly table according to claim 2, characterised in that the removal member is a pair of removal pincers (21), the jaws of which can be brought together or separated by means of the gripping device (20).

4. Assembly table according to claim 2 or 3, characterised by an initial-displacement device (23, 14 − 19) for the purpose of bringing a gripped integrated circuit (5') in a straight line out of a removal opening of the magazine (8) before the swivelling movement.

5. Assembly table according to one of the claims 2 to 4, characterised by a subsequent-displacement device (23) for the purpose of introducing a gripped integrated circuit (5') in a straight line into the receiving opening (30) after the swivelling movement.

6. Assembly table according to claim 5, characterised in that a single displacement device (23) achieves the initial- and subsequent-displacement.

7. Assembly table according to claim 6, characterised in that initial-displacement and subsequent-displacement comprise the same displacement distance.

8. Assembly table according to one of the claims 2 to 6, characterised by a straight-guiding device (14–18) for guiding the transfer apparatus (9) parallel to the assembly table (1) before and/or during the swivelling movement.

9. Assembly table according to claim 8, characterised in that the straight-guiding device (14–18) is formed by a carriage guide (14) in one piece with the assembly table (1) and by a carriage (19) connected with the swivelling device (25).

10. Assembly table according to claim 8 or 9, characterised by a cam lever (26) having a cam (27) which initiates the swivelling movement by being guided against a stop (28) during the straight line movement.

11. Assembly table according to one of the claims 2 to 10, characterised by pneumatic cylinders (15, 16, 23) for the control of the rectilinear movements.

12. Assembly table according to one of the claims 2 to 11, characterised by a pneumatic cylinder (22) for the control of the gripping device (20).

13. Assembly table according to one of the claims 1 to 12, characterised in that a bracket (13) associated with the magazine (8) is in one piece with the assembly table (1) and is parallel to it, the transfer apparatures (9) and, if appropriate, the carriage guide (14), being mounted on the said bracket (13).

14. Assembly table according to one of the claims 1 to 13, characterised in that the receiving opening (30) in the insert (31) is so arranged that the assembly tongs for the integrated circuit are coercively guided during removal of an inserted integrated circuit (5).

15. Assembly table according to claim 14, characterised in that the receiving opening (30) has plug holes (32) for the connecting lugs and/or pins of the respective integrated circuit (5).

16. Assembly table according to one of the claims 1 to 15, characterised in that the rotatable magazine (8) has several vertical receiving rails (12) for each specific type of integrated circuit (5″).

17. Assembly table according to claim 16, characterised by a rotary control of the rotatable magazine (8) which, subject to the type of the integrated circuit (5) which is to be inserted into the respective receiving opening (30), aligns the corresponding receiving rail (12) opposite the said transfer apparatus (9) for the integrated circuit removal by means of the transfer apparatur (9).

18. Assembly table according to claim 17, characterised by a positioning control (40, 41) for aligning the respective integrated circuit receiving rail (12) opposite the transfer apparatus (9).

19. Assembly table according to claim 18, characterised in that the positioning control has stop cam (40) in a given position at the magazine (8) and a switching device, such as a microswitch (41), operating together with a stop cam (40) in order to trigger the transfer apparatus (9) subject to an engagement between stop cam (40) and switching device.

20. Assembly table according to one of the claims 1 to 19, characterised by a triggering device (42, 43) for triggering the transfer apparatur (9) when the receiving opening (30) is arranged in a given position opposite the transfer apparatus (9).

21. Assembly table according to claim 20, characterised in that the triggering device has a switching device (42) operating together with the open container (6), if appropriate with the insert (31) or the receiving opening (30).

22. Assembly table according to one of the claims 19 to 21, characterised in that the positioning control (40, 41) and the triggering device (42, 43) operate together.

23. Assembly table according to claim 22, characterised in that the triggering device (42, 43) can be coded in order the position a given receiving rail (12) of the magazine (8) with regard to the transfer apparatus (9) subject to the respective coding.

24. Assembly table according to one of the claims 1 to 23, characterised in that the integrated circuits (5) can be conveyed programme controlled only by requirement and in a given sequence from the magazine (8) to the assembly position (2) by means of the transfer apparatus (9), the open container (6) provided with the receiving opening (30) and a conveying installation (7).

25. Assembly table according to one of the claims 2 to 24, characterised by a rotary device for turning the removal member after the integrated circuit (5) has been removed from the magazine (8) and before it is inserted into the receiving opening (30) for its alignment opposite the receiving opening (30).

26. Assembly table according to claim 25, characterised by a detecting member for detecting the alignment of the longitudinal axis of the integrated circuit (5) in the magazine (8) and a rotary control of the rotary device for triggering the latter to turn the integrated circuit (5), if appropriate additionally, by 180° about its longitudinal axis.

27. Assembly table according to claim 25 or 26, characterised in that the receiving opening (30) is arranged in the open container (6) in a position which in each case is given and corresponds to the final position of the integrated circuit (5) in the printed board (3).

**Revendications**

1. Table de fabrication pour garnir des cartes à circuits imprimés, comportant un poste de travail où l'on prend à la main des composants dans des nacelles de transport amenées par un système transporteur fonctionnant en circuit fermé, pour monter ces composants sur une carte à circuits imprimés disposée sur un support à l'endroit du poste de travail; un magasin d'alimentation étant en outre disposé sur la table de travail, pour contenir des circuits intégrés rangés dans un ordre déterminé; la table étant caractérisée en ce que, dans les nacelles de transport (6) prévues pour les circuits intégrés, sont montés des éléments interchangeables (31) qui présentent des évidements constituant des logements (30), adaptés à épouser la forme des circuits intégrés; et en ce qu'un dispositif de transfert (9) à fonctionnement automatique est prévu à l'endroit d'un poste de chargement (11) éloigné du poste de travail (2), pour prélever un à un les circuits intégrés (5, 5', 5'') dans le magasin (8), et pour engager chaque circuit intégré dans le logement (30) évidé de l'élément correspondant (31) d'une nacelle de transport, dans une position prédéterminée.

2. Table de fabrication selon la revendication 1, caractérisée en ce que le dispositif de transfert (9) comporte:
un organe de prélèvement pourvu d'un dispositif de préhension (20), pour prélever un circuit intégré (5) dans le magasin (8) et pour séparer le circuit intégré (5) de l'organe de prélèvement, lorsque le circuit intégré a été engagé dans le logement (30);
un système à mouvement oscillant (24, 25), pour faire pivoter l'organe de prélèvement à partir de la position de prélèvement (figure 2) ou un circuit intégré (5) peut être pris dans le magasin (8), jusqu'à une position d'engagement (figure 5), où le circuit intégré (5) peut être engagé dans le logement (30), et pour ramener ensuite l'organe de prélèvement à sa première position.

3. Table de fabrication selon la revendication 2, caractérisée en ce que l'organe de prélèvement est une pince de prélèvement (21), dont les mâchoires sont commandées par le dispositif de préhension (20) pour être rapprochées ou écartées l'une de l'autre.

4. Table de fabrication selon l'une des revendications 2 ou 3, caractérisée en ce qu'elle comporte un dispositif d'extraction (23, 14 – 19) pour extraire suivant un mouvement rectiligne un circuit intégré (5') qui vient d'être saisi par l'organe de prélèvement, en faisant sortir ce circuit intégré hors de son logement dans le magasin (8), afin de le séparer de cet organe avant le pivotement de l'organe de prélèvement.

5. Table de fabrication selon l'une des revendications 2 à 4, caractérisée en ce qu'elle comporte un dispositif d'introduction (23), pour introduire le circuit intégré (5') en cours de transfert, dans le logement (30), suivant un mouvement rectiligne, après le pivotement de l'organe de prélèvement.

6. Table de fabrication selon la revendication 5, caractérisé en ce qu'un même dispositif de déplacement (23) assure l'extraction initiale du circuit intégré hors de son logement ménagé dans le magasin (8) puis son introduction dans le logement de la nacelle de transport.

7. Table de fabrication selon la revendication 6, caractérisée en ce que le mouvement d'extraction et le mouvement d'introduction comportent des courses égales.

8. Table de fabrication selon l'une des revendications 2 à 6, caractérisée en ce qu'elle comporte un système de guidage rectiligne (14 – 18), pour guider le dispositif de transfert (9) parallèlement à la table de travail (1), avant et/ou pendant le mouvement de pivotement.

9. Table de fabrication selon la revendication 8, caractérisée en ce que le système de guidage rectiligne (14 – 18) est constitué par une glissière de guidage (14) solidaire de la table de travail (1), et par un coulisseau (19) relié au système oscillant (25).

10. Table de fabrication selon l'une des revendications 8 ou 9, caractérisée en ce qu'elle comporte un levier (26) pourvu d'une saillie (27) qui coopère avec une butée (28) contre laquelle vient porter la saillie sous l'action du mouvement coulissant rectiligne, pour provoquer le mouvement de pivotement.

11. Table de fabrication selon l'une des revendications 2 à 10, caractérisée en ce qu'elle comporte des vérins pneumatiques (15, 16, 23), pour comporte les mouvements rectilignes.

12. Table de fabrication selon l'une des revendications 2 à 11, caractérisée en ce qu'elle comporte un vérin pneumatique (22), pour actionner le dispositif de préhension (20).

13. Table de fabrication selon l'une des revendications 1 à 12, caractérisée en ce qu'elle comporte une poutre-support (13), solidaire de la table de travail (1) et parallèle à celle-ci, la poutresupport (13) étant reliée au magasin (8) pour recevoir le dispositif de transfert et éventuellement la glissière de guidage (14).

14. Table de fabrication selon l'une des revendications 1 à 13, caractérisée en ce que l'évidement servant de logement (30) est réalisé de telle manière dans l'élément (31) que la pince qui déplace chaque circuit intégré se trouve guidée de manière obligatoire pour assurer le déplacement du circuit intégré (5) par rapport au logement.

15. Table de fabrication selon la revendication 14, caractérisée en ce que l'évidement servant de logement (30) présente des trous d'enfichage (32) pour les broches de connexion de chaque circuit intégré (5).

16. Table de fabrication selon l'une des revendications 1 à 15, caractérisée en ce que le magasin d'alimentation tournant (8) présente plusieurs glissières verticales de guidage (12), prévues chacune pour recevoir un genre déterminé de circuits imprimés (5'').

17. Table de fabrication selon la revendication 16, caractérisée en ce qu'elle comporte un système pour commander le déplacement en rotation du magasin tournant (8), pour amener en regard du dispositif de transfert (9) la glissière de guidage appropriée (12), suivant le genre de circuit intégré (5) à monter dans chaque logement (30), afin de permettre l'enlèvement de ce circuit intégré par le dispositif de transfert (9).

18. Table de fabrication selon la revendication 17, caractérisée en ce qu'elle comporte un système de commande de positionnement (40, 41), pour présenter chaque glissière de guidage (12) contenant les circuits intégrés, exactement en regard du dispositif de transfert (9).

19. Table de fabrication selon la revendication 18, caractérisée en ce que le système de commande de positionnement comporte des crans de retenue (40) prévus chacun sur le magasin (8) en un endroit prédéterminé de celui-ci, et un dispositif de contact tel qu'un micro-contacteur (41) qui coopère avec les crans de retenue, pour déclencher le fonctionnement du dispositif de transfert (9) lorsque le dispositif de contact est en coïncidence avec les crans de retenue (40).

20. Table de fabrication selon l'une des revendications 1 à 19, caractérisée en ce qu'elle comporte un dispositif de déclenchement (42, 43), pour déclencher le fonctionnement du dispositif de transfert (9), lorsque l'évidement servant de logement (30) se trouve dans une position prédéterminée en regard du dispositif de transfert (9).

21. Table de fabrication selon la revendication 20, caractérisée en ce que le dispositif de déclenchement comporte un système de contacteur (42) qui coopère avec la nacelle de transport (6), ou éventuellement avec l'élément (31) contenu dans la nacelle, ou avec l'évidement servant de logement (30) ménagé dans cet élément.

22. Table de fabrication selon l'une des revendications 19 à 21, caractérisée en ce que le système de commande de positionnement (40, 41) coopère avec le dispositif de déclenchement (42, 43).

23. Table de fabrication selon la revendication 22, caractérisée en ce que le dispositif de déclenchement (42, 43) comporte un système d'indexation, de manière à assurer la mise en position d'une glissière de guidage prédéterminée (12) de l'organe d'alimentation (8), en regard du dispositif de transfert (9), suivant chacun des cas correspondants prévus dans le système d'indexation.

24. Table de fabrication selon l'une des revendications 1 à 23, caractérisée en ce qu'elle comporte des moyens de commande à programme, pour prélever à la demande et dans un ordre prédéterminé des circuits imprimés (5) dans le magasin (8), et pour les acheminer jusqu'au poste de travail (2), par l'intermédiaire du dispositif de transfert (9), de la nacelle de transport (6) pourvue de l'évidement servant de logement (30), et d'un système-convoyeur (7) pour déplacer la nacelle.

25. Table de fabrication selon l'une des revendications 2 à 24, caractérisée en ce qu'elle comporte un système de commande en rotation pour faire tourner l'organe de prélèvement après que celui-ci a pris un circuit intégré (5) dans le magasin (8), et avant l'introduction de ce circuit intégré dans l'évidement servant de logement (30), afin de présenter correctement le circuit intégré (5) en regard de cet évidement (30).

26. Table de fabrication selon la revendication 25, caractérisée en ce qu'elle comporte un organe détecteur, pour déterminer l'orientation de l'axe longitudinal du circuit intégré (5) dans le magasin (8), et un système de déclenchement associé à la commande en rotation, pour déclencher le fonctionnement de ce système, afin de faire tourner le circuit intégré (5) de 180° par rapport à son axe longitudinal.

27. Table de fabrication selon l'une des revendications 25 ou 26, caractérisée en ce que l'évidement servant de logement (30) est disposé dans la nacelle de transport (6) en chaque endroit de celle-ci correspondant à l'emplacement définitif de chaque circuit intégré (5) sur la carte à circuits imprimés (3) à réaliser.

# F I G . 1

FIG. 2

FIG. 3

FIG. 4

0 010 226

# F I G . 5

# F I G . 6